# EUROPEAN PATENT APPLICATION

(11) **EP 1 435 762 A1**
(43) Date of publication of application: **07.07.2004**
(21) Application number: 02765519.0
(22) Date of filing: 12.09.2002
(51) Int. Cl.: H05B 33/02, H05B 33/14, H05B 3/22, G02B 5/02, G09F 9/00, G09F 9/30

(54) **ORGANIC ELECTROLUMINESCENCE ELEMENT−USE TRANSPARENT SUBSTRATE AND ORGANIC ELECTROLUMINESCENCE ELEMENT**

(30) Priority: 13.09.2001 JP 2001277742
(71) Applicant: Nissan Chemical Industries, Ltd., Chiyoda-ku, Tokyo 101-0054 (JP)
(72) Inventor: OOTSUKA, Yoshikazu, Nissan Chemical Indus., Ltd., Tokyo 101-0054 (JP); ABE, Toyohiko, Nissan Chemical Industries, Ltd., Tokyo 101-0054 (JP); MOTOYAMA, Kenichi, Nissan Chemical Industries, Ltd, Funabashi-shi, Chiba 274 (JP)
(74) Representative: Hartz, Nikolai F., Dr.
(86) International application number: PCT/JP2002/009373
(87) International publication number: WO 2003/026357

(57) **Abstract**

Provided are a transparent substrate capable of improving the light extraction efficiency of an organic electroluminescence device, and a practical organic electroluminescence device using the substrate.

The present invention relates to a transparent substrate for an organic electroluminescence device characterized in that a region to disturb reflection and refraction angles of light emitted from a light-emitting device is provided on at least one side of the substrate, and an organic electroluminescence device having the substrate.

## Description

### TECHNICAL FIELD

The present invention relates to a substrate for an organic electroluminescence device, and an organic electroluminescence device using it.

### BACKGROUND ART

The organic electroluminescence devices are devices which have newly attracted attention with increasing demand for flat displays in recent years. A device configuration proposed by Tang and Vanslyke is one consisting of an anode, a hole transporting layer, an electron transporting light-emitting layer, and a cathode formed on a glass substrate (Appl. Phys. Lett., 51, 913, 1987). Other known devices include a device achieving lightweight and flexible natures by using a film substrate in place of the glass substrate (Semiconductor FPD World 2001, 6, 152), a device adopting a top emission scheme wherein the cathode in the above device configuration is made of a transparent material and a transparent film is placed thereon, so as to extract light from the cathode side (Semiconductor FPD World 2001, 4, 136), and so on. The organic electroluminescence devices have advantages over the liquid crystal devices commonly used heretofore as flat panel displays. Namely, the advantages are less viewing angle dependence by virtue of their being self-emitting devices, low power consumption, and capability of formation of extremely thin devices.

However, they still have many problems to be solved, in order to be applied to flat displays. One of the problems is a short emission lifetime of the device.

A present solution to this is an improvement in the material of the light-emitting layer out of the components of the device to achieve the lifetime of approximately ten thousand hours, which is less than a satisfactory lifetime for application of this device to the flat displays. The reason is that if a still image is displayed over a long period of time on a flat display in application of the short-lifetime device, there occurs an image retention phenomenon in which the difference in luminance between on pixels and off pixels is visually recognized as an after image. There are a lot of factors associated with the emission lifetime, but it is known that the lifetime becomes shorter as a higher voltage is applied to the device in order to enhance the luminance of emission.

However, the luminance of emission of the display using the organic electroluminescence device is not satisfied by application of a low voltage, but on the contrary the luminance of emission has to be increased by applying a high voltage to the device, in order to secure visibility of the display outdoors during the day. As described, the organic electroluminescence devices faced with such a dilemma that the luminance of emission needed to be lowered in order to lengthen the lifetime, whereas the lifetime became shorter with enhancement of visibility.

In order to solve this problem, improvements have energetically been made heretofore in the material of the light-emitting layer in the organic electroluminescence devices. Namely, attempts were made to develop emitting-layer materials with high internal energy efficiency, in order to achieve a high luminance of emission with application of a lower voltage.

On the other hand, Thompson et al. teach that the external energy efficiency indicating the luminous efficiency of the organic electroluminescence device can be expressed by the product of the internal energy efficiency and light extraction efficiency of the device (Optics Letters 22, 6, 396, 1997). Namely, it is necessary to increase not only the internal energy efficiency but also the light extraction efficiency, in order to increase the luminous efficiency of the organic electroluminescence device.

The light extraction efficiency is a rate of light released from the front face of the transparent substrate of the device into the atmosphere to light emitted in the device. Namely, the light emitted in the light-emitting layer needs to pass through interfaces between some media with different refractive indices before released into the atmosphere, and, according to the Snell's law of refraction, light incident at angles equal to or greater than the critical angle to each interface is totally reflected by the interface to propagate and dissipate in the layer or to be released through the side face of the layer, so that the light released from the front face of the device is decreased by that degree.

The foregoing Thompson et al. describe that the light extraction efficiency of the organic electroluminescence device is about 0.175, which means that approximately 18% of the light emitted in the light-emitting layer is extracted to the outside of the device but the rest, about 82%, is confined in the device to dissipate or is released from the side face of the device.

For this reason, a significant issue is to increase the light extraction efficiency and a variety of attempts have been made heretofore. The devices disclosed so far include one in which grain boundaries are formed in the transparent electrode or in the light-emitting layer so as to scatter visible light (JP-B-3-18320), one in which a glass substrate with one surface being roughened is used as a transparent substrate to scatter the light (JP-A-61-156691), and one in which a scattering region is provided in the vicinity of the interface between the electrode and the organic layer (JP-A-9-129375). However, these attempts all involve a risk of making the thickness of each layer of the device uneven and it can be the cause to induce dielectric breakdown and unevenness of emission of the device; therefore, those attempts were not satisfactory in terms of mass productivity of the device. Therefore, the problem of low light extraction efficiency of the organic electroluminescence device still remains unsolved.

The present invention has been accomplished on the basis of the above-mentioned background and an object thereof is to provide a transparent substrate capable of achieving an improvement in the light extraction efficiency of the organic electroluminescence device and to provide a practical organic electroluminescence device using the substrate.

### DISCLOSURE OF THE INVENTION

The present invention provides a transparent substrate for an organic electroluminescence device having the following features, and an organic electroluminescence device using it.
(1) A transparent substrate for an organic electroluminescence device, wherein a region to disturb reflection and refraction angles of light emitted from a light-emitting device is provided on at least one side of the substrate.
(2) The substrate according to the above (1), wherein the region to disturb the reflection and refraction angles comprises a scattering layer containing fine particles and a binder, and the refractive index of the fine particles is different from that of the binder.
(3) The substrate according to the above (2), wherein a relative refractive index n determined by dividing the refractive index of the fine particles by the refractive index of the binder satisfies a condition of 0.5<n<2.0.
(4) The substrate according to the above (2) or (3), wherein the relative refractive index n between the binder and the fine particles is preferably in a range of 0.5<n<0.91, and the refractive index of the binder is higher than that of the fine particles.
(5) The substrate according to the above (2) or (3), wherein the relative refractive index n between the binder and the fine particles is preferably in a range of 1.09<n<2.0, and the refractive index of the binder is lower than that of the fine particles.
(6) The substrate according to any one of the above (2) to (5), wherein the fine particles are comprised of a metal, an inorganic oxide, a semiconductor, or an organic resin, and are particles of from 0.01 to 10 µm in diameter.
(7) The substrate according to any one of the above (2) to (6), wherein the binder is an organic polymer or an inorganic sol-gel material.
(8) The substrate according to any one of the above (1) to (7), wherein the transparent substrate is a silica glass, a soda glass, or an organic film.
(9) An organic electroluminescence device comprising the substrate as described in any one of the above (1) to (8).

### BRIEF DESCRIPTION OF THE DRAWINGS

Fig. 1 is a sectional view showing an application of the transparent substrate to the organic electroluminescence device, formed in Example 4.
Fig. 2 is a sectional view showing an illustration of internal confinement of light from the light-emitting layer in a case using a conventional transparent substrate.
Fig. 3 is a sectional view showing an illustration of scattering and extraction from the front face of the substrate, of light from the light-emitting layer in a case using the transparent substrate formed in Example 4. Description of Reference Symbols
   1. Transparent substrate
   2. Transparent electrode
   3. Organic layer including the light-emitting layer
   4. Electrode
   5. Light reflected on the interface between the transparent electrode and the transparent substrate and propagating in the device
   6. Light reflected on the interface between the transparent substrate and the atmosphere and propagating in the device
   7. Light not totally reflected on the interfaces, so as to be extracted from the device
   8a. Region to disturb reflection and refraction angles of incident light
   8b. Region to disturb reflection and refraction angles of incident light
   9. Transparent substrate for the organic electroluminescence device according to the present invention
   10. Light extracted to the outside of the device because of disturbance of reflection and refraction angles on the light-emitting layer side of the transparent substrate
   11. Light extracted to the outside of the device because of disturbance of reflection and refraction angles on the atmosphere side of the transparent substrate
   θ₁. Angle of total reflection on the interface between the transparent electrode and the transparent substrate
   θ₂. Angle of total reflection on the interface between the transparent substrate and the atmosphere

### BEST MODE FOR CARRYING OUT THE INVENTION

The transparent substrate for the organic electroluminescence device according to the present invention is characterized in that a scattering layer having a smooth surface is formed as a region to disturb reflection and refraction angles of light emitted from the light-emitting device, on both sides or on either one side of the transparent substrate of a glass, an organic film, or the like. The scattering layer can be obtained by roughening a surface of the substrate and then flattening it with a transparent resin or the like, by providing a scattering structure on a surface of the substrate, or by providing a porous layer on the surface. However, in view of mass productivity and surface smoothness, the scattering layer is preferably one obtained by dispersing fine particles in a binder and applying it onto the surface.

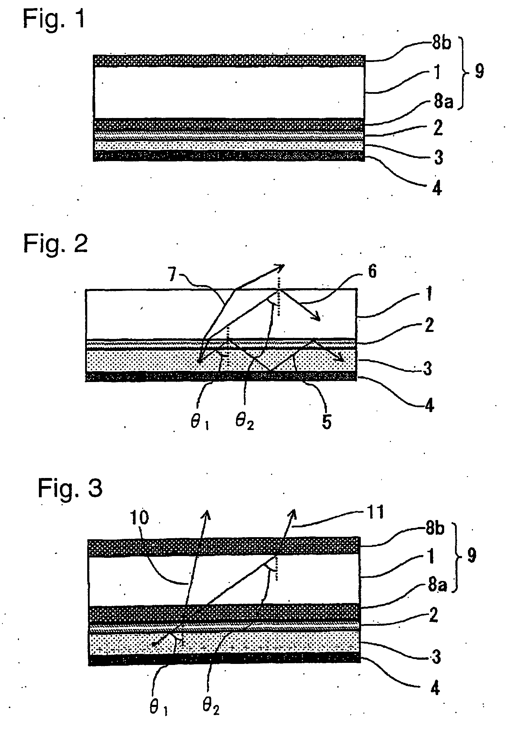

An example of the organic electroluminescence device using the transparent substrate of the present invention is shown in Fig. 1. The device in the configuration of Fig. 1 is normally fabricated by successively depositing a transparent electrode 2, an organic layer 3 including a light-emitting layer, and an electrode 4 on a transparent substrate 9 according to the present invention. Since these deposited layers are very thin, they may cause dielectric breakdown if the surface of the transparent substrate is rough. Therefore, the device-side surface of the transparent substrate 9 according to the present invention needs to be smoothed well.

The present invention is also applicable to the device configuration of the top emission scheme, and in this scheme the light-emitting device is formed on another substrate and thereafter combined with the transparent substrate according to the present invention.

Light emitted from the light-emitting layer of the organic electroluminescence device passes through each of the layers in the device to reach the transparent substrate. In a case using a conventional transparent substrate 1, as shown in Fig. 2, reflection and refraction occur between the transparent electrode 2 and transparent substrate 1, and light incident at angles equal to or greater than the critical angle θ₁ is totally reflected. The totally reflected light 5 is again totally reflected on another electrode surface 3, and through repetitions of this process the light propagates in the device to dissipate. Even light incident at angles below the critical angle θ₁ into the transparent substrate is again subject to reflection and refraction on the interface between the transparent substrate 1 and the atmosphere, and light 6 incident at angles equal to or greater than the critical angle θ₂ is totally reflected and propagates in the transparent substrate, so as to result in failure in extracting the light from the front face of the substrate. Namely, as long as the conventional transparent substrate was used, nothing but light 7 incident at angles smaller than the critical angles θ₁ and θ₂ of total reflection on the interfaces was extracted from the front face of the device.

On the other hand, with use of the transparent substrate 9 having regions 8a, 8b to disturb the reflection and refraction angles on either side or on both sides of the substrate according to the present invention, as shown in Fig. 3, the incident light becomes multidirectional in the regions 8a, 8b. Therefore, even light 10, 11 incident at angles equal to or greater than the critical angles θ₁, θ₂ to the interfaces with the transparent substrate can be extracted from the front face of the transparent substrate. Furthermore, even the light confined in the device stops propagating in the device by virtue of the scattering regions 8a, 8b, and almost whole light can be extracted eventually from the front face of the transparent substrate. Accordingly, the external luminous efficiency of the ordinary organic electroluminescence devices can be largely increased by merely using the transparent substrate 9 according to the present invention and, in turn, it becomes feasible to achieve both the satisfactory emission luminance and lifetime of the organic electroluminescence devices as described previously.

The transparent substrate applied to the present invention is a transparent substrate such as a silica glass, a soda glass, or an organic film. The substrate may be one with a color filter or a black matrix on the surface thereof. The region to disturb the reflection and refraction angles of the incident light (hereinafter referred to also as a "scattering layer") is formed on either one side or on both sides of the transparent substrate.

Specifically, this region is one that is comprised of at least two substances with mutually different refractive indices, and that has an interface between the substances complicatedly disordered to induce the disturbance of the reflection and refraction angles. In order to avoid the diffraction phenomenon such as a moire pattern, the disorder of the interface between the substances is desirably one without microscopic regularity. In addition, in order to improve the light extraction efficiency of the device, it is better to reduce backward scattering of the region and to increase forward scattering. It can be achieved by roughening the surface of the substrate and then flattening it with a transparent resin or the like, by providing a scattering structure on the surface of the substrate, by providing a porous layer on the surface, or by adopting a combination of these. However, in view of the mass productivity, surface smoothness, and forward scattering, the scattering layer to be employed is one in which the fine particles are dispersed in the binder, preferably in a ratio of 0.01 to 100 parts by weight and more preferably in a ratio of 0.1 to 10 parts by weight of the binder relative to 100 parts by weight of the fine particles.

The fine particles used here are particles of spherical, plate-like or other shape, which are 0.01 to 10 µm in diameter. The material for the particles may be any material out of organic substances and inorganic substances, and is determined taking the dispersibility in the binder, the coating property onto the transparent substrate, the refractive index, transparency, and others into account. The fine particles can be used in a single kind or in mixture of two or more kinds. In the case of the mixture of two or more kinds, the fine particles may be two or more kinds of fine particles different in the refractive index, or different simply in the particle size.

The fine particles to be used can be metal particles of gold, silver, copper, chromium, nickel, zinc, iron, antimony, platinum, rhodium, and so on, metal salt particles of AgCl, AgBr, AgI, CsI, CsBr, CsI, and so on, semiconductors particles of ZnS, ZnSe, ZnTe, CdS, CdSe, CdTe, AlAs, AlSb, GaP, GaAs, GaSb, InP, InAs, InSb, SiC, PbS, HgS, Si, Ge, and so on, inorganic oxide particles of TiO₂, SrTiO₃, SiO₂, ZnO, MgO, Ag₂O, CuO, Al₂O₃, B₂O₃, ZrO₂, Li₂O, Na₂O, K₂O, BaO, CaO, PbO, P₂O₅, Cs₂O, La₂O₃, SrO, WO₃, CdO, Ta₂O₅, and so on, and inorganic particles of mixture of these; and organic particles of polyacrylate, polymethacrylate, polystyrene, polyurethane, benzoguanamine, silicone resin, melamine resin, and so on. It is preferable to apply the silica particles, the polyacrylate particles, or the polystyrene particles.

The binder is a substance that facilitates the dispersion of the above fine particles and that is excellent in the coating property onto the transparent substrate. The material for the binder may be any material out of organic substances and inorganic substances, and is determined taking the dispersibility of the fine particles, the coating property onto the transparent substrate, the refractive index, the transparency, and others into account. The binder can also be a thermoplastic, thermosetting, or ultraviolet curing binder.

The binder to be used can be one selected from urethane substances, acrylic substances, acrylic-urethane copolymer substances, epoxy resin substances, melamine resin substances, polyvinyl acetal substances, polyvinyl alcohol substances, polycarbonate resin substances, and sol-gel materials of metal alkoxide hydrolysates. Among them, the preferred materials are the sol-gel materials of alkoxysilane hydrolysates, acrylic resin, polyvinyl butyral, polycarbonate resin, and so on.

When a relative refractive index of the fine particles to the refractive index of the binder (a value obtained by dividing the refractive index of spherical particles by the refractive index of a transparent polymer binder, which will be hereinafter referred to simply as a "relative refractive index") is defined as n, the relative refractive index n falls preferably in a range of 0.5<n<2.0 and particularly preferably in a range of 0.5<n<0.91 or 1.09<n<2.0.

Furthermore, as to the refractive index of the whole scattering layer, it is preferable that the refractive index of the scattering layer on the atmosphere side be close to that of the transparent substrate used and that the refractive index of the scattering layer on the device side be close to that of the transparent electrode. The refractive index n' of the whole scattering layer is preferably in a range of 1.20<n'<2.00.

The scattering layer may be doped with another substance such as a dispersing agent, a leveling agent, a coloring agent, a plasticizer, a cross-linking agent, a photosensitive material, a sensitizer, a surfactant, or the like as occasion demands.

Incidentally, the particles do not necessarily exist only inside the layer, but they may also exist in the vicinity of the surface or project out from the surface. The particles projecting out from the surface make the surface uneven and it can be the cause to induce dielectric breakdown of the organic electroluminescence device. In such cases, the surface of the scattering layer should be smoothed by a method such as polishing, pressing, application of a transparent planarizing layer, or the like.

Now, an example of a method of producing the transparent substrate for the organic electroluminescence device according to the present invention will be described.

First, the aforementioned binder is adjusted into an appropriate viscosity with a solvent or the like, and thereafter the aforementioned fine particles are dispersed therein by a method such as stirring, a sand mill, a jet mill, or the like to prepare a coating liquid. Then the coating liquid is applied up to a predetermined thickness on one side of the transparent substrate by a method such as a spin coater, printing, or the like, and thereafter dried and cured by a method such as hot-air drying, UV curing, or the like depending on the coating liquid, to form the transparent substrate for the organic electroluminescence device.

In a case in which the scattering layer is formed onto both sides of the transparent substrate, a dip method can be applied instead of the above method.

Then the transparent substrate with the scattering layer thereon may be subjected to smoothing, if necessary, by a method such as polishing, pressing, application of a transparent planarizing film, or the like.

The present invention will be explained below in further detail with examples, and these should be considered merely as illustrative but not restrictive on the present invention.

### EXAMPLE 1

20.8 g of tetraethoxysilane as an alkoxysilane and 70.1 g of ethanol as a solvent were fed into a reaction flask equipped with a reflux tube, and stirred and mixed with a magnetic stirrer. 0.1 g of oxalic acid dissolved in 9 g of water was added thereto as a catalyst and mixed. After the mixing, the liquid temperature increased by about 10°C. The liquid was continuously stirred in that state for 30 minutes, then warmed at 76°C for 60 minutes, and then cooled to the room temperature to prepare a solution containing solid matter in a concentration of 6 mass % as SiO₂. This solution was applied onto a silicon substrate and baked. The refractive index was measured and found to be 1.32.

10 g of the solution as prepared above, 13.3 g of a silica sol containing silica particles (refractive index: 1.35) 30 mass % as SiO₂ with a particle size of 80 nm and IPA (isopropanol) as a dispersion medium, and 34.2 g of ethanol and 57.5 g of butyl cellosolve as solvents were mixed with the magnetic stirrer, to prepare a coating liquid. The coating liquid had a solid content mass ratio of 6/40.

The coating liquid thus obtained was applied onto a soda lime glass substrate having a thickness of 1.1 mm and a transmittance of 91% at the wavelength of 550 nm, by use of a spin coater to form a film. The film was dried at 80°C for 5 minutes on a hot plate, and heated at 300°C for 60 minutes in a clean oven to obtain a cured film having a thickness of about 1000 Å (angstrom). Then the transmittance of the film was measured at the wavelength of 550 nm with a spectrophotometer (W-160 type manufactured by SHIMADZU CORPORATION) and found to be 94.8%.

Another cured film having a thickness of about 1000 Å (angstrom) was formed on a silicon substrate in the same manner, and the refractive index was measured and found to be 1.32. The refractive index was measured by an ellipsometer (manufactured by Mizojiri Optical Co., Ltd.).

### EXAMPLE 2

700 g of polyvinyl butyral was dissolved in 630 g of n-butanol. Thereafter, 400 g of methanol, 100 g of water, and 5 g of tetramethoxysilane as a cross-linking agent were added thereto and stirred until the mixture became uniform. Then 1 g of P-toluenesulfonic acid as a curing catalyst, and 1 g of a surfactant were added into the mixture and stirred. The refractive index of only the binder was 1.40. Then, 20 g of an aqueous solution (solid content concentration: 0.1 mass %) containing dispersed silver chloride particles (refractive index: 2.09) in particle size of 1 µm was added into the mixture and stirred further for one hour to prepare a coating liquid. The coating liquid was applied onto an acrylic substrate, which was pre-treated by being exposed to ultraviolet rays from a low-pressure mercury lamp for one minute, by the dip coat method at a drawing rate of 2 mm/sec. The resultant films were subjected to a heat treatment at 100°C for 15 minutes, whereby the films were cured to prepare a transparent substrate with the scattering layers of this Example.

### EXAMPLE 3

240 g of bisphenol A type polycarbonate resin (viscosity-average molecular weight: 40,000, refractive index: 1.65) and 60 g of methylene chloride were dissolved and mixed. 80 volume % of the mixed solution and 20 volume % of acrylic resin particles (available from Soken Chemical & Engineering Co., Ltd., number-average particle size: 0.5 µm, refractive index: 1.45) were mixed and the particles were dispersed by ultrasonic waves for 2 hours. The solution was applied onto a glass substrate by a spin coat method (840 rpm; 10 seconds), pre-baked at 100°C for 10 minutes, and then post-baked at 230°C for 20 minutes in an oven, to prepare a transparent substrate with the scattering layer of this Example.

### EXAMPLE 4

Organic electroluminescence devices were fabricated using the transparent substrates with the scattering layer or layers obtained in above Examples 1 to 3, and the transparent substrate without the scattering layer as a comparative example. An indium-tin oxide (ITO) layer was formed as a transparent electrode in the thickness of 100 nm by sputtering on the scattering layer of each transparent substrate. At this time the sheet resistance was 20 Ω/cm². The following layers were successively formed on the surface of the transparent electrode: the hole-transporting layer having a thickness of 70 nm of an oligoaniline derivative described in Japanese Patent Application No. 2000-341775 previously filed by the present applicant (one obtained by dissolving an aniline pentamer in DMF and doping it with 3-fold mol equivalent of 5-sulfosalicylic acid); the light-emitting layer having a thickness of 50 nm of N,N'-bis(1-naphthyl)-N,N'-diphenyl-1,1'-bisphenyl-4,4'-diamine (α-NPD); and the electron-transporting layer having a thickness of 50 nm of tris(8-hydroxyquinoline)aluminum (Alq₃). Then a magnesium-silver alloy was evaporated to form a cathode. In this case the thickness of the cathode was 200 nm.

A voltage of 10 V was applied between both electrodes of the organic electroluminescence devices formed in this manner, to measure the quantity of emission from the front face of the transparent substrate. The measured values of the devices formed with the transparent substrates of Examples 1 and 2 were compared relative to that of the comparative example defined as 1.

As a result, the device of Example 1 demonstrated the value of 1.1, the device of Example 2 the value of 1.5, and the device of Example 3 the value of 1.3, and it was confirmed from the result that the use of the transparent substrate according to the present invention significantly increased the luminance of surface emission from the organic electroluminescence devices of conventional structure.

### INDUSTRIAL APPLICABILITY

As detailed above, the substrate for the organic electroluminescence device according to the present invention is excellent in mass productivity, and, by constructing the device using the substrate, the light extraction efficiency to the outside can be improved without inducing uneven emission, dielectric breakdown, or the like.

## Claims

1. A transparent substrate for an organic electroluminescence device, wherein a region to disturb reflection and refraction angles of light emitted from a light-emitting device is provided on at least one side of the substrate.

2. The substrate according to Claim 1, wherein the region to disturb the reflection and refraction angles comprises a scattering layer containing fine particles and a binder, and the refractive index of the fine particles is different from the refractive index of the binder.

3. The substrate according to Claim 2, wherein a relative refractive index n determined by dividing the refractive index of the fine particles by the refractive index of the binder satisfies a condition of 0.5<n<2.0.

4. The substrate according to Claim 2 or 3, wherein the refractive index of the binder is higher than the refractive index of the fine particles.

5. The substrate according to Claim 2 or 3, wherein the refractive index of the binder is lower than the refractive index of the fine particles.

6. The substrate according to any one of Claims 2 to 5, wherein the fine particles are comprised of a metal, an inorganic oxide, a semiconductor, or an organic resin and are particles of from 0.01 to 10 µm in diameter.

7. The substrate according to any one of Claims 2 to 6, wherein the binder is an organic polymer or an inorganic sol-gel material.

8. The substrate according to any one of Claims 1 to 7, wherein the transparent substrate is a silica glass, a soda glass, or an organic film.

9. An organic electroluminescence device comprising the substrate as defined in any one of Claims 1 to 8.
